(19) Europäisches Patentamt
European Patent Office
Office européen des brevets

(11) **EP 3 817 206 B1**

(12) **EUROPEAN PATENT SPECIFICATION**

(45) Date of publication and mention
of the grant of the patent:
**01.11.2023 Bulletin 2023/44**

(21) Application number: **19206989.6**

(22) Date of filing: **04.11.2019**

(51) International Patent Classification (IPC):
*H02M 1/12* (2006.01)      *H02M 1/44* (2007.01)
*H10N 30/40* (2023.01)

(52) Cooperative Patent Classification (CPC):
**H02M 1/126; H02M 1/12; H10N 30/40;** H02M 1/123

(54) **OUTPUT FILTER FOR POWER TRAIN**

AUSGABEFILTER FÜR ANTRIEBSSTRANG

FILTRE DE SORTIE POUR TRANSMISSION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**05.05.2021 Bulletin 2021/18**

(73) Proprietor: **Hamilton Sundstrand Corporation
Charlotte, NC 28217 (US)**

(72) Inventors:
• **CASTRO, Ignacio
Gijón (ES)**

• **POPEK, Grzegorz
Birmingham, B14 5QH (GB)**

(74) Representative: **Dehns
St. Bride's House
10 Salisbury Square
London EC4Y 8JD (GB)**

(56) References cited:
WO-A1-2009/025129      JP-A- 2001 298 963
JP-A- 2005 143 216      KR-A- 20040 005 706
US-A1- 2005 281 061      US-A1- 2009 252 515
US-A1- 2016 329 483

**Description**

TECHNICAL FIELD

The present disclosure relates to an output filter to mitigate transmission line effects and dv/dt at the load end of a power train such as in an AC motor drive system.

BACKGROUND

Power trains typically include a power source connected to a load such as a motor via a power convertor/inverter. For example a three phase AC motor is conventionally driven from a power supply. If the power supply is AC power, a rectifier will convert the AC power to DC power on a DC link. An inverter provides the required three-phase AC power, e.g. at a different frequency from the power supply, to drive the motor, from the DC power. The drive power for the motor is often transmitted to the motor over long cables or lines.

The power cables have an inherent inductance and capacitance, and a mismatch between the cable impedance and the connected motor and other components can cause electrical reflections along the power cable. The inverter motor generates a PWM voltage pattern at the output. Sharp edges of the PWM signal interacting with the cable can cause a rapid increase in voltage creating a voltage surge at the motor terminals. These surges or spikes of current and voltage can cause so-called transmission line effects at the motor terminals. Such surges can have amplitudes of double the DC link voltage. Such phenomena are described extensively in the literature, e.g. E. Persson, "Transient effects in application of PWM inverters to induction motors," in IEEE Transactions on Industry Applications, vol. 28, no. 5, pp. 1095-1101, Sept.-Oct. 1992. J. C. G. Wheeler, "Effects of converter pulses on the electrical insulation in low and medium voltage motors," in IEEE Electrical Insulation Magazine, vol. 21, no. 2, pp. 22-29, March-April 2005. A. von Jouanne and P. N. Enjeti, "Design considerations for an inverter output filter to mitigate the effects of long motor leads in ASD applications," in IEEE Transactions on Industry Applications, vol. 33, no. 5, pp. 1138-1145, Sept.-Oct. 1997. Prasad Enjeti, Dudi Rendusara, and Annette von Jouanne, "Method and System for an Improved Converter Output Filter for an Induction Drive System", U.S. Patent 6,122,184; September 19, 2000. D. A. Rendusara and P. N. Enjeti, "An improved inverter output filter configuration reduces common and differential modes dv/dt at the motor terminals in PWM drive systems," in IEEE Transactions on Power Electronics, vol. 13, no. 6, pp. 1135-1143, Nov. 1998. P. Mart-ro, W. Sae-Kok and S. Khomfoi, "Analysis of dv/dt filter installation for PWM AC drive applications," 2011 IEEE Ninth International Conference on Power Electronics and Drive Systems, Singapore, 2011, pp. 177-184. K. K. Yuen and H. S. Chung, "A Low-Loss "RL-Plus-C" Filter for Overvoltage Suppression in Inverter-Fed Drive System With Long Motor Cable," in IEEE Transactions on Power Electronics, vol. 30, no. 4, pp. 2167-2181, April 2015. N. Aoki, K. Satoh and A. Nabae, "Damping circuit to suppress motor terminal overvoltage and ringing in PWM inverter-fed AC motor drive systems with long motor leads," in IEEE Transactions on Industry Applications, vol. 35, no. 5, pp. 1014-1020, Sept.-Oct. 1999. A. F. Moreira, P. M. Santos, T. A. Lipo and G. Venkataramanan, "Filter networks for long cable drives and their influence on motor voltage distribution and common-mode currents," in IEEE Transactions on Industrial Electronics, vol. 52, no. 2, pp. 515-522, April 2005. J. He, G. Y. Sizov, P. Zhang and N. A. O. Demerdash, "A review of mitigation methods for overvoltage in long-cable-fed PWM AC drives," 2011 IEEE Energy Conversion Congress and Exposition, Phoenix, AZ, 2011, pp. 2160-2166.K. K. Yuen, H. S. Chung and V. S. Cheung, "An Active Low-Loss Motor Terminal Filter for Overvoltage Suppression and Common-Mode Current Reduction," in IEEE Transactions on Power Electronics, vol. 27, no. 7, pp. 3158-3172, July 2012. T. Shimizu, M. Saito, M. Nakamura and T. Miyazaki, "A Motor Surge Voltage Suppression Method With Surge Energy Regeneration," in IEEE Transactions on Power Electronics, vol. 27, no. 7, pp. 3434-3443, July 2012. K. K. Yuen and H. S. Chung, "Use of Synchronous Modulation to Recover Energy Gained From Matching Long Cable in Inverter-Fed Motor Drives," in IEEE Transactions on Power Electronics, vol. 29, no. 2, pp. 883-893, Feb. 2014. Z. Liu and G. L. Skibinski, "Method to reduce overvoltage on AC motor insulation from inverters with ultra-long cable," 2017 IEEE International Electric Machines and Drives Conference (IEMDC), Miami, FL, 2017, pp. 1-8. These effects can cause damage to the motor windings and/or conductor insulation which can result in failure of the motor.

Today, wide band-gap rapid switching components made of SiC and GaN are often used for their improved switching properties, but these can create transmission line effects even in shorter cables. This means that the faster switching advantage of such devices is not fully exploited.

Various solutions to transmission line effects have been proposed, such as providing an oversized motor (less desirable where weight and size constraints apply such as in aircraft), or providing a passive filter (RC or RLC) at the inverter output or at the motor terminals. Such solutions, however, can result in excessive loss and the need to provide a bigger heat sink which increases the weight of the converter and reduces it attractiveness.

In one approach, transmission line effects are managed by an output RLC filter which 'slows down' the edges of the PWM signal to the motor. Such an arrangement can, however, lead to losses due to power dissipation. This is particularly problematic in e.g. aerospace applications because of excessive heatsink size. The use of capacitors can also give rise to reliability concerns.

An alternative approach to handling transmission line effects is the use of an RL output filter. Such a filter dissipates less power and does not have the problems associated with capacitors.

Output filters often dissipate large amounts of energy at their resistors, which negates the benefits of the new fast-switching devices.

Other solutions involve providing active circuits that match the cable impedance while being able to generate energy. RC components are selected to provide a certain terminating resistance to avoid high frequency components, achieved by matching the resistance to the characteristic impedance of the cable. Alternatively, RC components are selected to slow the voltage rise (dv/dt) at the motor terminal to acceptable levels for twice the time delay of the transmission line. RC terminators tend to dissipate less energy than RLC circuits and so can be preferable. The use of capacitors, again, however, can give rise to reliability issues.

Another solution, found to reduce power losses, uses a sinewave filter comprising inductive and capacitive components. Such a filter is essentially lossless due to not having resistive components. Such filters are generally designed to have a cut-off frequency at the logarithmic half frequency between the grid frequency and the switching frequency. The filter is then completely independent of cable length. A problem with such a filter, though, is that the cut-off frequency requirement means that the inductor needs to be large and will be heavy, which is undesirable, particularly in aerospace applications. Such filters also have the disadvantages mentioned above due to the use of capacitors.

Another problem with known power drives is that fast dv/dt transitions can inject a large common mode (CM) current into the chassis of the system such that the system is no longer compliant with e.g. EMI requirements. Large CM current can also contribute to ageing of the motor assembly.

Most of the solutions proposed for managing transmission line effects, discussed above, will not have significant impact on the CM current.

It would be desirable to provide an output filter at the load end of a power train that effectively and efficiently manages transmission line effects without the use of a capacitor and having low losses. It would also be desirable if such a filter could recycle the energy required to damp the voltage overshoot. Such a device could then be efficiently used with GaN or SiC - based devices, in which their beneficial properties can be fully exploited.

In this regard, it is generally known to exploit the filter and transformer properties of piezoelectric transformers for suppressing common mode noise and for energy harvesting.

For example, JP2001298963 describes a motor drive system with an EMC filter, a rectifier, a voltage source inverter and a common mode choke. An auxiliary coil detects a common mode noise current and drives a piezoelectric transformer, which injects a compensation current into a ground wire of the motor based on the detected noise current. Furthermore, US2009252515 proposes the operation of a piezoelectric transformer as a sine wave generator for sensing purposes, while US2016329483 indicates, that piezoelectric transformers are commonly used in micro power energy harvesting to power remote sensors.

## SUMMARY

According to the disclosure, there is provided a power train as defined by claim 1 for a high impedance load, comprising: an input EMC filter for connection to a power supply; a converter connected to an output of the input EMC filter; and an output filter connected to the output of the converter, the output filter comprising three piezoelectric transformers, one for each phase line of the converter, and respective inductors, the respective inductors of the phase lines being connected at the inputs of the piezoelectric transformers, wherein all three piezoelectric transformers share the same load; and the load is a power converter configured to regenerate switching energy.

The load element(s) may be a resistor or a power converter.

A high impedance load (understood as high impedance at high frequencies), e.g. a motor, will be connected to the output of the filter, usually via long cables.

## BRIEF DESCRIPTION OF THE DRAWINGS

Figure 1 is a schematic diagram of the components of a typical power train for a motor.
Figure 2a shows a typical piezoelectric transformer for use in a damper.
Figure 2b is an equivalent circuit of the piezoelectric transformer of Fig. 2a.
Figure 3 is a schematic circuit diagram of an output filter incorporating piezoelectric transformers.
Figure 4 is a single phase equivalent circuit of an output filter incorporating a piezoelectric transformer.
Figure 5a shows an ideal transfer function for a conventional RC damper.
Figure 5b shows an ideal transfer function of an output filter incorporating a piezoelectric transformer.

Figure 6 is a three-phase power train incorporating an output filter with piezoelectric transformers.

Figure 7 is a single-phase power train incorporating an output filter with a piezoelectric transformer.

Figure 8 is a three-phase power train with a common load incorporating an output filter according to the invention.

Figure 9 is a power train with a star arrangement and a possible chassis connection incorporating an output filter with a loaded piezoelectric transformer.

Figure 10 is a power train with a Delta arrangement and a possible chassis connection incorporating an output filter with a loaded piezoelectric transformer.

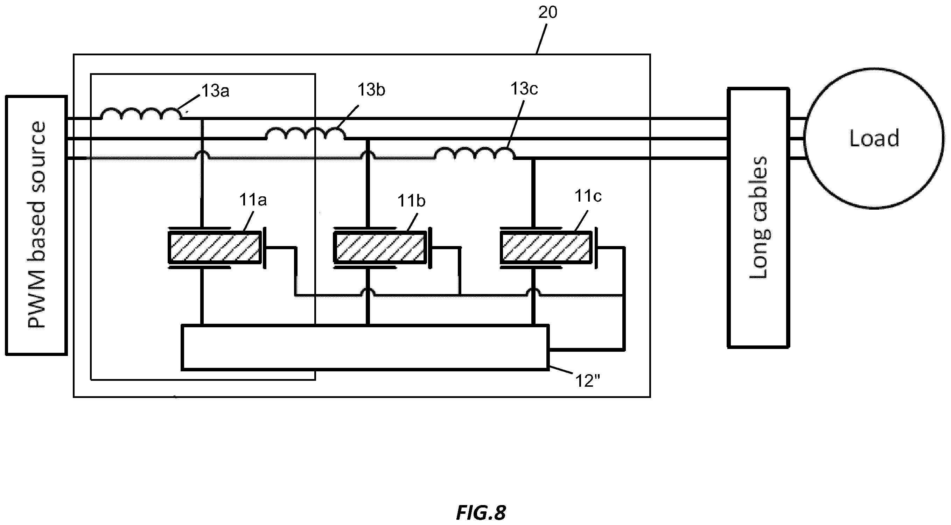

The embodiment related to claim 1 is schematically shown in fig. 8.

DETAILED DESCRIPTION

The described embodiments are by way of example only. The scope of this disclosure is limited only by the claims.

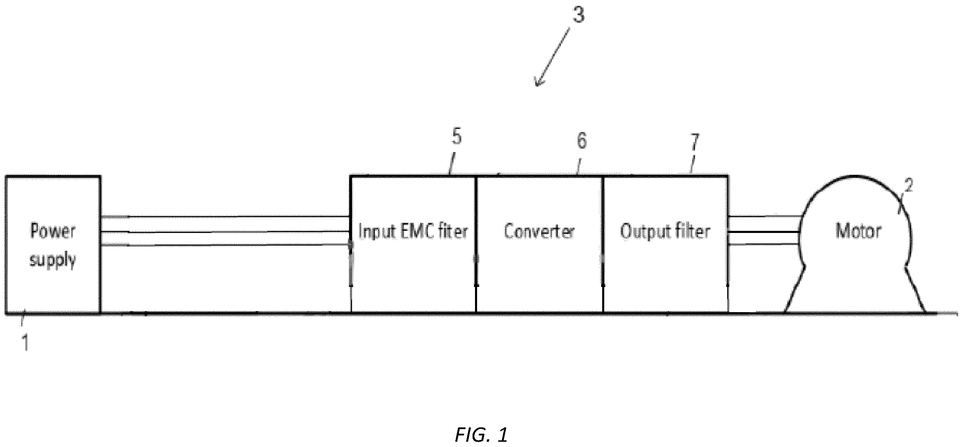

A typical power train for a motor is described with reference to Fig. 1. Power is provided from a power supply 1 to a motor 2 along a power train 3. The power from the power supply 1 passes through a converter which comprises, here, an input EMC filter 5 to reduce high frequency electronic noise that may cause interference with other devices, and a main converter 6. An output filter 7 is then generally provided to mitigate transmissions line effects as described above. The converter and input and output filters are mounted to a system chassis, e.g. a copper plate.

As described above, various solutions have been proposed to address transmission line effects including those in CM mode. The output filter of the present disclosure aims to address transmission line effects without the use of capacitors.

The present disclosure makes use of a piezoelectric transformer (PZT) to replace the capacitive component of a sinewave filter to recreate the effect of an RLC damper but without the use of a capacitor or resistor.

Piezoelectric materials have found an increasing number of applications in recent times due to their characteristics that enable electrical energy to be generated due to compressing or lengthening the piezoelectric component.

PZTs are solid state devices made up of two piezoelectric materials. One generates voltage when compressed, the other lengthens when a voltage is applied. By appropriate selection of the piezoelectric materials, such PZTs can be used as step up or step down transformers.

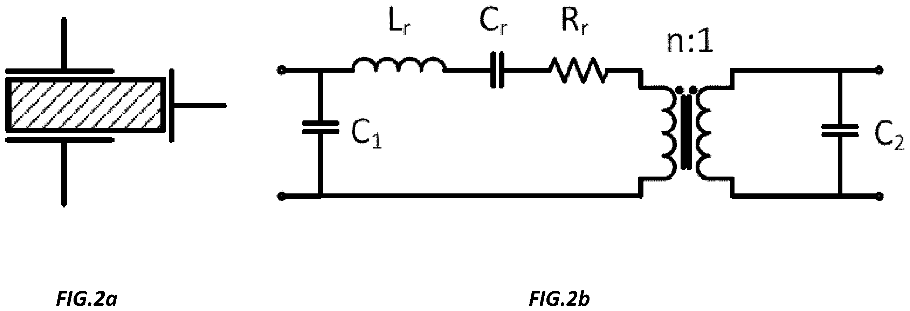

Figs. 2a and 2b show a typical PZT (Fig 2a) and the circuit equivalent of a PZT (Fig. 2b). From the equivalent circuit it can be seen that if the input (C1) and output (C2) capacitances are removed, or set to zero, the PZT has the equivalent structure of an RLC circuit. This can be used to function as an RLC filter. In addition, a load needs to be added to the output of the PZT to either passively control the overshoot (e.g. a resistive element) or to actively recycle energy (if the load is a converter) and to control the overshoot.

An RLC filter bases its operation on controlling the dv/dt of the PWM. The traditional design for such an output filter is described in A. von Jouanne and P. N. Enjeti, 'Design considerations for an inverter output filter to mitigate the effects of long motor leads in ASD applications,' IEEE transactions on Industry applications, vol. 33, no. 5, pp. 1138-1145, Sept-Oct. 1997 where it was concluded that the value of the resistance should match the characteristic impedance of the cable in order to minimise losses. This study, however, considered the effects of varying the values of L, C and R to understand their impact on not just losses but also weight, overshoot, volume and electromagnetic compliance (EMC). The study found that the value of L heavily impacts on dv/dt but has little impact on overshoot. The value of C, on the other hand, hardly impacts dv/dt but fully controls the overshoot. The value of R affects both. To minimise weight, losses and achieve a certain overshoot, it was found that the value of R should not necessarily match the characteristic impedance of the cable but should, in some cases, be much lower. In summary, experiments have shown that the parameters of an RLC filter can be selected to achieve a certain overshoot without requiring a resistor with the value of the characteristic impedance of the cable in order to minimise the weight whilst accepting higher losses.

The arrangement of the present disclosure starts from a sinewave filter and replaces the capacitor of such filter with a loaded piezoelectric transformer (PZT) in order to attain a similar behaviour to the RLC topology discussed above, whilst eliminating the capacitor and having the possibility of recycling the power taken by the resistor.

The analysis that follows is for simplicity, for a single phase system, but applies correspondingly for two-phase, three-phase or other multi-phase systems.

The filter is located at the output of the drive to the motor, before the the long cables connecting the drive to the motor, and the configuration is analysed to obtain an input impedance Z in which is obtained from the Thevenin equivalent of an RLC circuit such as described in K.K. Yuen and H.S. Chung, "A Low-Loss "RL-plus-C" Filter for Overvoltage Suppression in Inverter-fed Drive System With Long Motor Cable", in IEEE Transactions on Power Electronics, vol. 30, no. 4, pp. 2167-2181, April 2015.

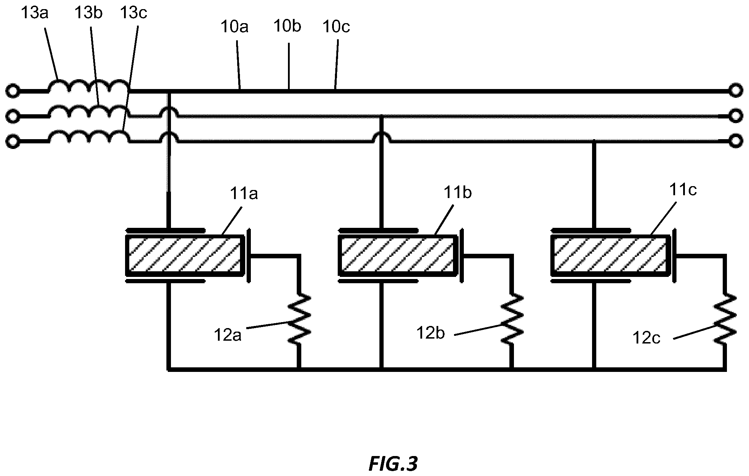

Fig. 3 is a circuit diagram showing how such a loaded PZT can be connected to the motor terminal for a three phase system. For each phase line 10a, 10b, 10c there is provided a respective inductor 13a,b,c and a respective PZT 11a, 11b, 11c each loaded with a respective resistive element or converter 12a, 12b, 12c. The same principle can be applied to a single or other multi-phase system. For the sake of simplicity, the structure for a single phase system will be used for the following description.

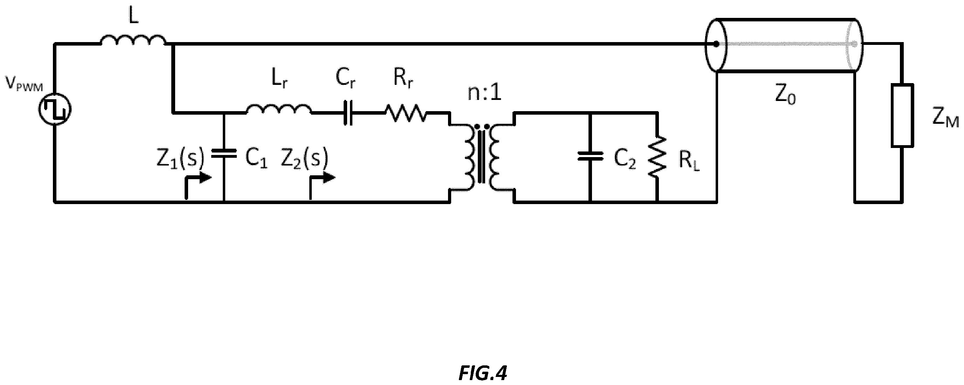

Fig. 4 shows the equivalent circuit for a single phase system. The PZT is represented as shown in Fig. 2b to which a resistive load $R_L$ is added across the load capacitor $C_2$ and an inductor L is added at the input. $Z_M$ is the motor impedance.

The transfer function of a conventional RC damper is defined using the equation:

$$Z_2(s) = \frac{s^3 L_r C_r C_2 R_L n^2 + s^2 (C_r R_r C_2 R_L + L_r C_r n^2) + s(C_r L_r + C_r R_r n^2 + C_2 R_L) + 1}{s^2 C_r C_2 R_L + s C_r n^2}$$

Then, $Z_1(s)$ can be defined as,

$$Z_1(s) = \frac{Z_2(s)}{1 + s C_1 Z_2(S)}$$

and $Z_{in}(s)$ by,

$$Z_L(s) = \frac{Z_1(s) sL}{Z_1(s) + sL}$$

Following the same reasoning, $Z_{in}(s)$ can be obtained for the case of the traditional LRC filter, which is calculated as:

$$Z_{in}(s) = \frac{LRC + sL}{s^2 LC + sRC + 1}$$

The objective is for the input impedance $Z_{in}(s)$ to be equal to $Z_0$ at high frequencies. This is the condition that guarantees no voltage reflection and thus no overshoot. The other condition that needs to be satisfied is that the impedance needs to be theoretically 0 at lower frequencies to not impact the performance of either driver or motor. Then,

$$Z_{in}(s) = \begin{cases} 0 & \omega < \omega_c \\ Z_0 & \omega \geq \omega_c \end{cases}$$

Therefore the objective is to attain a similar transfer function for the proposed filter. In order to analyse the position of the zeroes and the poles, $C_2$ has been eliminated and $R_L$ and $C_1$ are considered as a single entity. This simplification can be done because $C_2$ only causes effects at very high frequencies that are not of interest here. Then, $Z_{in}(s)$ can be written for the proposed filter as,

$$Z_{in}(s) = \frac{(s^2 L_r C_r + s C_r R_L + 1) sL}{s(C_r + C_1)(s^2 L_r C_{eq} + s C_{eq} R_L + 1) + sL}$$

and where $C_{eq}$ can be defined by,

$$C_{eq} = \frac{C_1 C_r}{C_r + C_1}$$

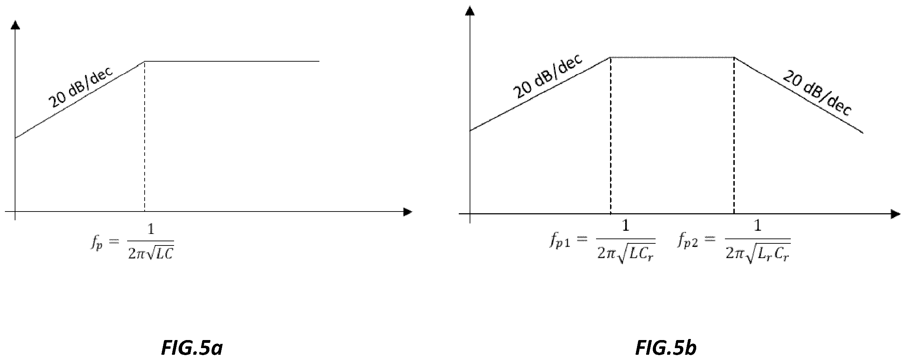

Figure 5a and Figure 5b show the ideal transfer function for the traditional LRC filter and the proposed solution, respectively. In the case of the position of zeroes and poles for the proposed solution not all have been considered and only the most important ones have been detailed. As can be seen, the low frequency performance of both filters is identical if the PZT output filter is well designed, the difference starts for really high frequencies (out of the range of interest here) at which the transmission line effect is diminished. In addition, it is also important to diminish the value of

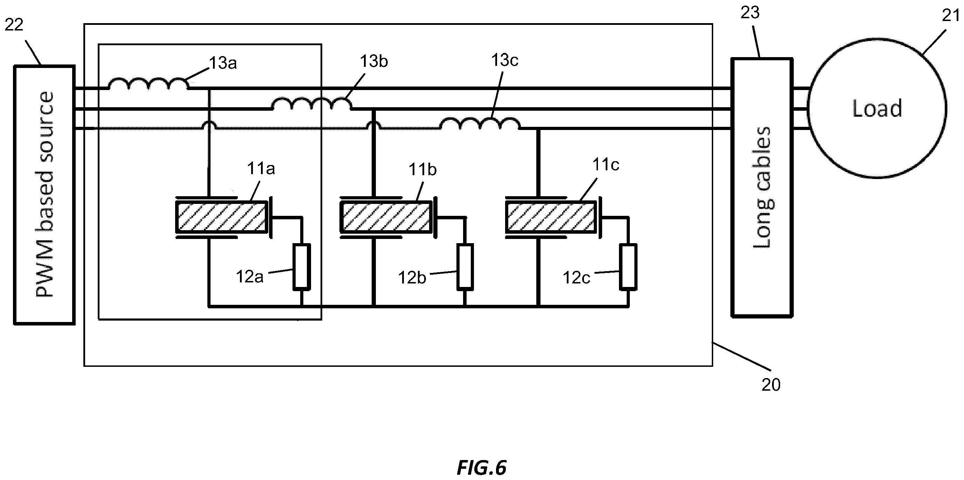

$L_r$ in order to push $f_{p2}$ as far as possible. Figure 6 shows a comparison of a custom PZT with similar characteristics to the traditional LRC filter, showing that the transfer function is identical for low frequencies as stated before. In addition, the comparison between the approximation and the actual transfer function shows the accuracy of the approximation. This analysis shows the mathematical validation for the filter to show its potential. But as has been discussed before, matching the value of the resistor to $Z_0$ is not a proper way to have an optimized for aerospace filter.

If, instead of a resistor load, the PZT is loaded with a converter, this value $R_L$ can be controlled to enable recycling of energy and also to adapt the power within a certain range. The load can also be adjusted to work for cables of different lengths.

Figs. 6 to 10 show some alternative ways, as examples only, of how the connection of piezoelectric transformers can be implemented in a power train.

All of Figs. 6 to 10 show, schematically, a filter 20 incorporating one or more piezoelectric transformers connected at the terminals of a load - i.e. here a motor 21. The motor 21 is connected to a power source 22 (here a PWM-based power source) via cables 23 which can be very long. The filter 20 is located at the output of the drive.

Fig. 6 shows a three phase system in which the structure of the damper 20 is the same as shown and described in relation to Fig. 3. The same reference numerals are used for corresponding components in Fig. 6.

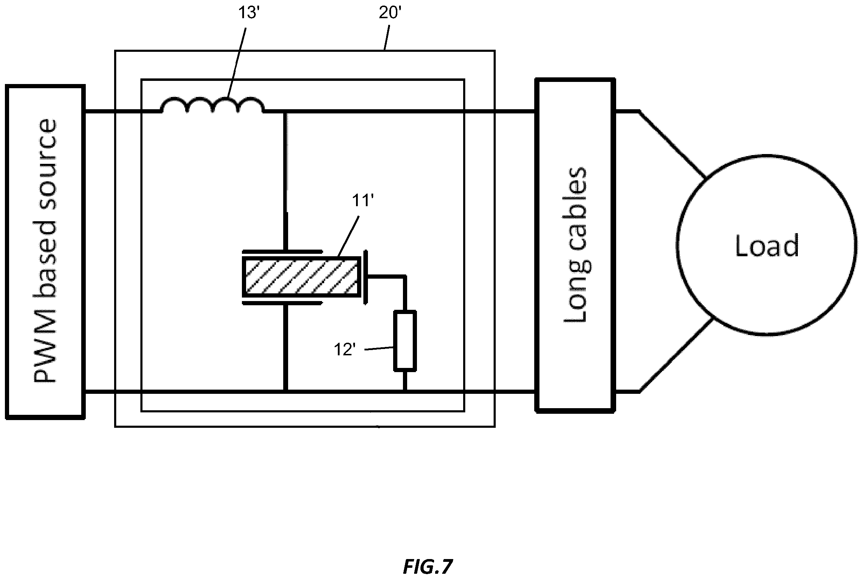

Fig. 7 shows a single phase system, where the damper 20' comprises a single PZT 11' loaded with a resistive element 12' or a converter.

Fig. 8 shows a three phase system similar to that of Fig. 6 but all three PZTs 11a, 11b, 11b share the same load 12" being a power converter according to the invention.

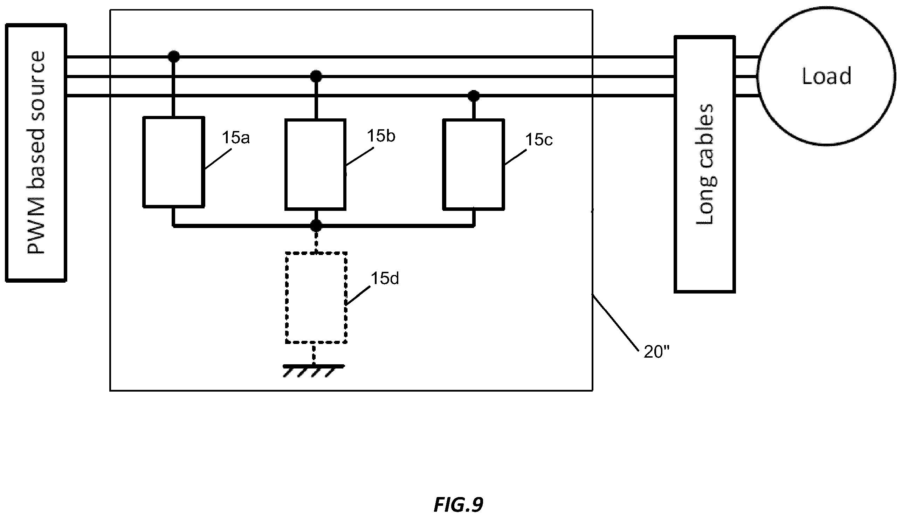

Fig. 9 shows an alternative three phase system where the damper structures for each phase (here a block 15a, 15b, 15c, 15d) representing a loaded PZT as previously described, are arranged in a star configuration 20" where the start point may be connected to the system chassis directly or via an additional damper 5d. In such an arrangement, some of the loads may be passive and some active.

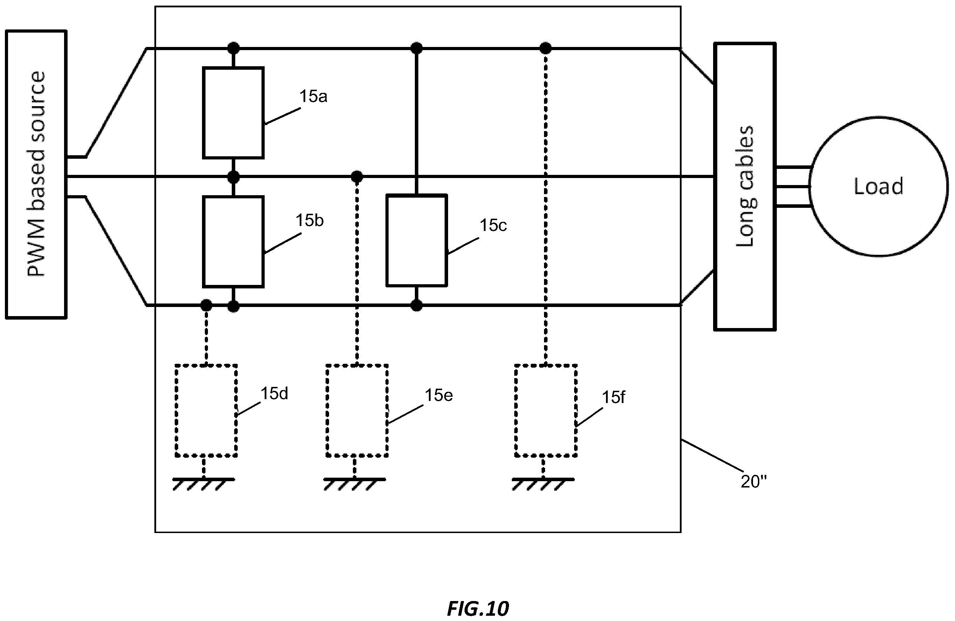

Fig. 10 shows the filter structures arranged in a "Delta" configuration 20‴ referenced to the system chassis either directly or via additional dampers 15e, 15f, 15g.

The output filter can be used in a power train with a PWM based source to manage transmission line effects. The damper can also reduce dv/dt at the motor terminals, reduced common mode currents and reduce stress on the motor windings.

The description is of preferred embodiments only. The scope of protection is defined by the claims.

### Claims

1. A power train for a high impedance load, comprising:

   an input EMC filter (5) configured to be connected to a power supply (1);
   a converter (6) connected to an output of the input EMC filter (5); and
   an output filter (7) connected to the output of the converter, the output filter (7) comprising three piezoelectric transformers (11a, 11b, 11c), one for each phase line (10a, 10b, 10c) of the converter (6), and respective inductors (13a, 13b, 13c), the respective inductors (13a, 13b, 13c) of the phase lines (10a, 10b, 10c) being connected at the inputs of the piezoelectric transformers (11a, 11b, 11c), wherein all three piezoelectric transformers (11a, 11b, 11c) share the same load (12"); and the load (12") is a power converter configured to regenerate switching energy.

2. The power train of claim 1, further comprising the power supply (1).

3. The power train of any preceding claim, further comprising a high impedance load (2) connected to an output of the output filter.

4. The power train of claim 3, wherein the high impedance load is a motor (2).

5. The power train of claim 3 or 4, wherein the high impedance load is connected to the output of the output filter via cables.

### Patentansprüche

1. Antriebsstrang für eine Last mit hoher Impedanz, umfassend:

einen Eingabe-EMV-Filter (5), der dazu konfiguriert ist, an eine Stromversorgung (1) angeschlossen zu werden; einen Wandler (6), der mit einer Ausgabe des Eingabe-EMV-Filters (5) verbunden ist; und einen Ausgabefilter (7), der mit der Ausgabe des Wandlers verbunden ist, wobei der Ausgabefilter (7) drei piezoelektrische Transformatoren (11a, 11b, 11c), einen für jede Phasenleitung (10a, 10b, 10c) des Wandlers (6) und jeweilige Induktoren (13a, 13b, 13c) umfasst, wobei die jeweiligen Induktoren (13a, 13b, 13c) der Phasenleitungen (10a, 10b, 10c) an den Eingaben der piezoelektrischen Transformatoren (11a, 11b, 11c) angeschlossen sind, wobei alle drei piezoelektrischen Transformatoren (11a, 11b, 11c) die gleiche Last (12") teilen; und die Last (12") ein Stromwandler ist, der dazu konfiguriert ist, Schaltenergie zu regenerieren.

2. Antriebsstrang nach Anspruch 1, ferner umfassend die Stromversorgung (1).

3. Antriebsstrang nach einem der vorhergehenden Ansprüche, ferner umfassend eine Last (2) mit hoher Impedanz, die mit einer Ausgabe des Ausgabefilters verbunden ist.

4. Antriebsstrang nach Anspruch 3, wobei die Last mit hoher Impedanz ein Motor (2) ist.

5. Antriebsstrang nach Anspruch 3 oder 4, wobei die Last mit hoher Impedanz über Kabel mit der Ausgabe des Ausgabefilters verbunden ist.

**Revendications**

1. Groupe motopropulseur pour une charge à haute impédance, comprenant :

un filtre CEM d'entrée (5) configuré pour être connecté à une alimentation électrique (1) ; un convertisseur (6) connecté à une sortie du filtre CEM d'entrée (5) ; et un filtre de sortie (7) connecté à la sortie du convertisseur, le filtre de sortie (7) comprenant trois transformateurs piézoélectriques (11a, 11b, 11c), un pour chaque ligne de phase (10a, 10b, 10c) du convertisseur (6) , et des inductances respectives (13a, 13b, 13c), les inductances respectives (13a, 13b, 13c) des lignes de phase (10a, 10b, 10c) étant connectées aux entrées des transformateurs piézoélectriques (11a, 11b, 11c), dans lequel les trois transformateurs piézoélectriques (11a, 11b, 11c) partagent la même charge (12") ; et la charge (12") est un convertisseur de puissance configuré pour régénérer l'énergie de commutation.

2. Groupe motopropulseur selon la revendication 1, comprenant en outre l'alimentation électrique (1).

3. Groupe motopropulseur selon une quelconque revendication précédente, comprenant en outre une charge à haute impédance (2) connectée à une sortie du filtre de sortie.

4. Groupe motopropulseur selon la revendication 3, dans lequel la charge à haute impédance est un moteur (2).

5. Groupe motopropulseur selon la revendication 3 ou 4, dans lequel la charge à haute impédance est connectée à la sortie du filtre de sortie via des câbles.

*FIG. 1*

EP 3 817 206 B1

FIG.2a

FIG.2b

EP 3 817 206 B1

FIG.3

**FIG.4**

EP 3 817 206 B1

*FIG.5b*

*FIG.5a*

FIG.6

FIG.7

*FIG.8*

*FIG.9*

**FIG.10**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6122184 A
- JP 2001298963 B
- US 2009252515 A
- US 2016329483 A

### Non-patent literature cited in the description

- **E. PERSSON.** Transient effects in application of PWM inverters to induction motors. *IEEE Transactions on Industry Applications,* September 1992, vol. 28 (5), 1095-1101
- **J. C. G. WHEELER.** Effects of converter pulses on the electrical insulation in low and medium voltage motors. *IEEE Electrical Insulation Magazine,* March 2005, vol. 21 (2), 22-29
- **A. VON JOUANNE ; P. N. ENJETI.** Design considerations for an inverter output filter to mitigate the effects of long motor leads in ASD applications. *IEEE Transactions on Industry Applications,* September 1997, vol. 33 (5), 1138-1145
- **D. A. RENDUSARA ; P. N. ENJETI.** An improved inverter output filter configuration reduces common and differential modes dv/dt at the motor terminals in PWM drive systems. *IEEE Transactions on Power Electronics,* November 1998, vol. 13 (6), 1135-1143
- **P. MART-RO ; W. SAE-KOK ; S. KHOMFOI.** Analysis of dv/dt filter installation for PWM AC drive applications. *2011 IEEE Ninth International Conference on Power Electronics and Drive Systems, Singapore,* 2011, 177-184
- **K. K. YUEN ; H. S. CHUNG.** A Low-Loss "RL-Plus-C" Filter for Overvoltage Suppression in Inverter-Fed Drive System With Long Motor Cable. *IEEE Transactions on Power Electronics,* April 2015, vol. 30 (4), 2167-2181
- **N. AOKI ; K. SATOH ; A. NABAE.** Damping circuit to suppress motor terminal overvoltage and ringing in PWM inverter-fed AC motor drive systems with long motor leads. *IEEE Transactions on Industry Applications,* September 1999, vol. 35 (5), 1014-1020
- **A. F. MOREIRA ; P. M. SANTOS ; T. A. LIPO ; G. VENKATARAMANAN.** Filter networks for long cable drives and their influence on motor voltage distribution and common-mode currents. *IEEE Transactions on Industrial Electronics,* April 2005, vol. 52 (2), 515-522
- **J. HE ; G. Y. SIZOV ; P. ZHANG ; N. A. O. DEMER-DASH.** A review of mitigation methods for overvoltage in long-cable-fed PWM AC drives. *2011 IEEE Energy Conversion Congress and Exposition, Phoenix, AZ,* 2011, 2160-2166
- **K. K. YUEN ; H. S. CHUNG ; V. S. CHEUNG.** An Active Low-Loss Motor Terminal Filter for Overvoltage Suppression and Common-Mode Current Reduction. *IEEE Transactions on Power Electronics,* July 2012, vol. 27 (7), 3158-3172
- **T. SHIMIZU ; M. SAITO ; M. NAKAMURA ; T. MIYAZAKI.** A Motor Surge Voltage Suppression Method With Surge Energy Regeneration. *IEEE Transactions on Power Electronics,* July 2012, vol. 27 (7), 3434-3443
- **K. K. YUEN ; H. S. CHUNG.** Use of Synchronous Modulation to Recover Energy Gained From Matching Long Cable in Inverter-Fed Motor Drives. *IEEE Transactions on Power Electronics,* February 2014, vol. 29 (2), 883-893
- **Z. LIU ; G. L. SKIBINSKI.** Method to reduce overvoltage on AC motor insulation from inverters with ultra-long cable. *2017 IEEE International Electric Machines and Drives Conference (IEMDC), Miami, FL,* 2017, 1-8
- **A. VON JOUANNE ; P. N. ENJETI.** Design considerations for an inverter output filter to mitigate the effects of long motor leads in ASD applications. *IEEE transactions on Industry applications,* September 1997, vol. 33 (5), 1138-1145
- **K.K. YUEN ; H.S. CHUNG.** A Low-Loss "RL-plus-C" Filter for Overvoltage Suppression in Inverter-fed Drive System With Long Motor Cable. *IEEE Transactions on Power Electronics,* April 2015, vol. 30 (4), 2167-2181